Europäisches Patentamt

European Patent Office

Office européen des brevets

(19)

(11) Publication number: 0 298 430
A2

(12) # EUROPEAN PATENT APPLICATION

(21) Application number: 88110725.4

(22) Date of filing: 05.07.88

(51) Int. Cl.⁴: H01L 29/00 , H01L 29/78 ,
H01L 27/10

(30) Priority: 08.07.87 JP 168643/87
28.10.87 JP 270189/87
26.10.87 JP 268107/87

(43) Date of publication of application:
11.01.89 Bulletin 89/02

(84) Designated Contracting States:
DE FR GB

(71) Applicant: HITACHI, LTD.
6, Kanda Surugadai 4-chome
Chiyoda-ku Tokyo 101(JP)

(72) Inventor: Kume, Hitoshi
1-33-7, Nishikubo
Musashino-shi Tokyo(JP)
Inventor: Yamamoto, Hideaki
1-25-2, Higashitokorozawa
Tokorozawa-shi Saitama-ken(JP)
Inventor: Tsukada, Toshihisa
3-29-2, Sekimae
Musashino-shi Tokyo(JP)
Inventor: Kamigaki, Yoshiaki
2-41-11, Higashitokorozawa
Tokorozawa-shi Saitama-ken(JP)
Inventor: Adachi, Tetsuo
1-48-18, Akatsuki-cho
Hachioji-shi Tokyo(JP)
Inventor: Kure, Tokuo
1-217, Higashikoigakubo
Kokubunji-shi Tokyo(JP)

(74) Representative: Strehl, Schübel-Hopf,
Groening, Schulz
Widenmayerstrasse 17 Postfach 22 03 45
D-8000 München 22(DE)

(54) Semiconductor device having a floating gate.

(57) In a semiconductor device having a floating gate electrode (16), an electric field to be applied to a gate oxide film (14) is locally modulated in a region where the floating gate electrode (16) overlaps a drain or source region (21). The device of the present invention is well suited for application as a nonvolatile memory cell, and it exhibits a slight leakage current in an erase operation and has a high immunity against the drain disturb phenomenon.

FIG. 5

## Semiconductor device having a floating gate

### Background of the Invention

The present invention relates to a semiconductor device having a floating gate, and more particularly to a floating-gate nonvolatile memory cell which is electrically erasable and which has a small cell area.

As a semiconductor device having a floating gate, a nonvolatile memory cell has heretofore been disclosed in, for example, IEEE, Journal of Solid-State Circuits, SC-15 (1983), pp. 532-538.

The memory cell mentioned above is constructed of a MISFET (Metal-Insulator-Semiconductor Field Effect Transistor) which has a floating gate electrode and a control gate electrode. It performs a write operation or an erase operation in such a way that electrons are injected from a substrate into the floating gate through a thin oxide film underlying the floating gate, owing to the Fowler-Nordheim tunneling, or that electrons are emitted from the floating gate into the substrate owing to the Fowler-Nordheim tunneling. On this occasion, a high electric field in excess of 10 MV/cm needs to be applied to the thin oxide film. For the purpose of realizing this situation with an external applied voltage which is as low as possible, it is necessitated to set a large area as the stacked area of the floating gate electrode and the control gate electrode. Accordingly, the memory cell has its cell area made about 5 times as large as the cell area of an ultraviolet-erased EPROM (Erasable Programmable Read Only Memory) which similarly has a floating gate electrode and a control gate electrode. This has been disadvantageous for attaining a higher density of integration and a larger memory capacity.

On the other hand, a memory cell which can reduce its cell area to become equal to the cell area of the EPROM cell while keeping the electrical erase function has been proposed in Technical Digest of International Electron Device Meeting (1985), pp. 616-619.

This cell is constructed of a MISFET which has fundamentally the same structure as that of the conventional EPROM cell, but it is characterized in that a gate oxide film underneath a floating gate electrode is a tunneling oxide film which is thin over the whole channel. Although the conventional EPROM cell is erased by irradiation with ultraviolet radiation, this proposed cell is electrically erased in such a way that a high electric field in excess of 10 MV/cm is applied to the tunneling oxide film between the floating gate electrode and a source region. Concretely, a positive high voltage is applied to only the source region in the state in which at least a control gate electrode and a semiconductor substrate are grounded. On this occasion, the coupling capacitance between the source region and the floating gate electrode is low. Therefore, even if the stacked area of the floating gate electrode and the control gate electrode is consciously enlarged, the high electric field can be efficiently applied to the tunneling oxide film. That is, the electrical erasure is permitted with the cell area which is nearly equal to that of the conventional EPROM cell. Meanwhile, regarding a write operation, a high electric field is generated within the semiconductor substrate at an edge part where a drain region lies in contact with the channel, and hot carriers are used for the writing. This is quite the same as in the case of the conventional EPROM.

In the prior art described above, the gate oxide film underneath the floating gate electrode is thinned entirely and uniformly. For this reason, problems to be stated below have been inevitable.

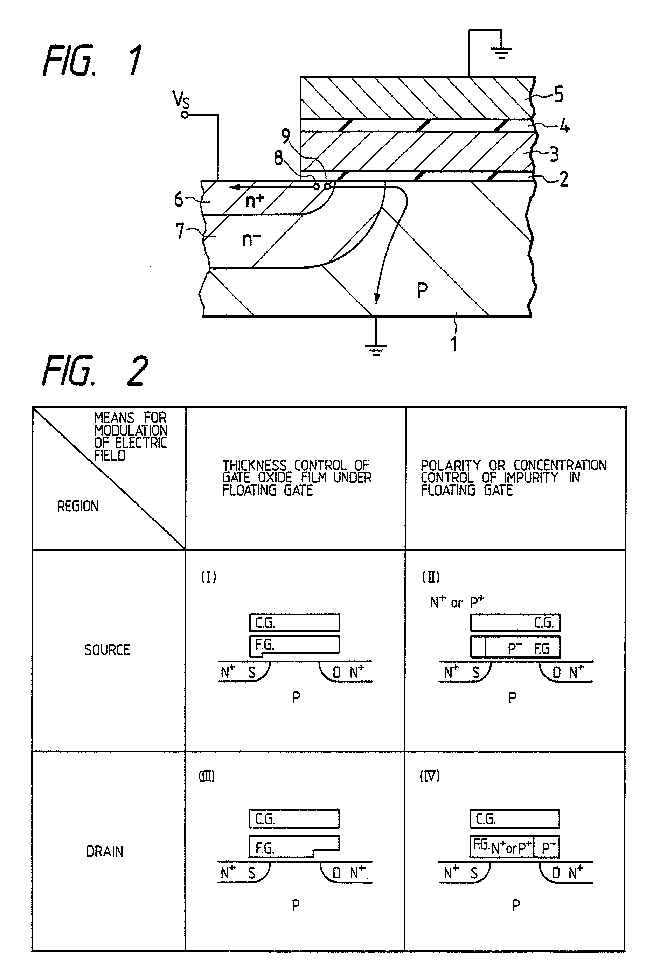

The first problem is that, in the erase operation, an unnecessary leakage current which flows from the source region to the semiconductor substrate cannot be satisfactorily reduced. Now, this problem will be briefly explained with reference to Fig. 1.

Fig. 1 is a sectional view showing especially the stacked parts of the source region and the control gate electrode/floating gate electrode in the memory cell structure based on the prior art. Numeral 1 designates a p-type semiconductor substrate, numeral 2 a gate oxide film which is thinned wholly, numeral 3 a floating gate electrode, numeral 4 an inter-layer dielectric or insulator film, numeral 5 a control gate electrode, numeral 6 an $n^+$-type semiconductor region, and numeral 7 an $n^-$-type semiconductor region. The $n^-$-type semiconductor region 7 is diffused to be deeper than the $n^+$-type semiconductor region 6, and when combined, the regions 6 and 7 form a high-breakdown-voltage source region of the so-called double diffusion type.

The erase operation of the memory cell is realized in such a way that electrons which are stored charges are emitted from the floating gate electrode 3 into the $n^+$-type semiconductor region 6 on the basis of the Fowler-Nordheim tunneling. More specifically, a positive high voltage is applied to the $n^+$-type semiconductor region 6 with the control gate electrode 5 and the p-type semiconductor substrate 1 grounded, whereby a tunneling electric field in excess of 10 MV/cm is applied to that part of the gate oxide film 2 at which the $n^+$-type semiconductor region 6 and the floating gate electrode 3 overlap. On this occasion, in the surface of the n$^+$-type semiconductor region 6 at the overlap part, the surface potential exceeds an inversion potential (2 $\emptyset_F$) to establish a deep depletion state in, at least, a region on a lower concentration side (the right-hand edge region of the n$^+$-type semiconductor region 6 as viewed in Fig. 1), and pairs of electrons 8 and holes 9 are generated by band-to-band tunneling based on an intense vertical electric field.

When the holes 9 generated here flow out to the p-type semiconductor substrate 1, they are detected as a source-substrate leakage current. In this regard, in the memory cell structure according to the prior art, the path of the holes extending from the hole generating region and along the surface of the semiconductor appears (in other words, an energy barrier to the holes is not formed). It has therefore been difficult to eliminate the hole leakage current which flows through the path.

Since the presence of the hole leakage current conspicuously increases a consumptive current in the erase operation, the number of bits of the memory cells which can be collectively erased is limited. In addition, the deep depletion state of the surface of the n$^+$-type semiconductor region 6 continues steadily during the erase operation because of the removal of the holes to the side of the p-type semiconductor substrate 1. In consequence, the injection and capture of the holes into the gate oxide film (tunneling oxide film) are not negligible, and they lower the reliability of a rewrite operation.

As the second problem, there arises conspicuously the drain disturb phenomenon that, in the operation of writing data into a desired memory cell, the threshold voltages of memory cells connected to the same data line as that of the desired cell lower.

More specifically, the gate oxide film is thinned even at a gate electrode edge on the side of the drain region. Therefore, when a write voltage is applied to only the data line, an electric field intensity at the edge part of the drain region rises markedly, and avalanche which is not negligible takes place. Some of hot holes generated here are injected from the substrate into the floating gate, thereby to incur the drain disturb phenomenon. Besides, there must be considered the possiblity that electrons will be emitted from the floating gate electrode into the drain region due to the tunneling ascribable to the write voltage applied to the drain region.

For avoiding the drain disturb phenomenon stated above, it is required to lower the write voltage (drain voltage). This, however, forms a serious restriction to ensuring a writing speed of certain standard.

## Summary of the Invention

An object of the present invention is to provide with a cell area nearly equal to that of an EPROM cell, the structure of a nonvolatile memory cell which has an electrically erasing function and in which a consumptive current (leakage current) during an erase operation is low.

The second object of the present invention is to provide with a cell area nearly equal to that of an EPROM cell, the structure of a nonvolatile memory cell which has an electrically erasing function and in which the reliability of an erase operation is high.

The third object of the present invention is to provide with a cell area nearly equal to that of an ultraviolet-erased EPROM cell in the prior art, a nonvolatile memory cell which exhibits an excellent immunity against the drain disturb phenomenon and affords a high writing speed while keeping an electrically erasing function.

The fourth object of the present invention is to provide a high-performance MISFET the drain-gate coupling capacitance of which is low and the drain avalanche breakdown voltage of which is high at the cutoff of a channel.

The objects are accomplished by a structure according to which an electric field to be applied to a gate oxide film is locally modulated in a region where a floating gate electrode overlaps at least either of a drain region and a source region.

As a more concrete example of means for locally modulating the electric field, in the region where the floating gate electrode overlaps at least either of the drain region and the source region, the thickness of the gate oxide film or the conductivity type or concentration of an impurity with which the floating gate electrode made of polycrystalline silicon is locally changed. Regarding the more concrete means, four cases on an N-channel memory cell are illustrated in Fig. 2.

In Case (I), a gate oxide film underneath a floating gate electrode is partly thinned, the thinned region being limited to the edge part of the floating gate electrode on the side of a source region, and the N$^+$ high-concentration region of the source region is spread to the side of a channel region beyond the thinned region.

In Case(III), that edge part of a gate oxide film which covers a drain region and a partial channel region continuous thereto is locally thickened.

In Case (II), the impurity profile of a floating gate electrode is so set that the edge part of the floating gate electrode on the side of a source region has a high impurity concentration, whereas the other part thereof has a low impurity concentration in the conductivity type opposite to that of the source region, and the N$^+$ high-concentration region of the source region is spread to the side of a channel region beyond the high impurity concentration part.

In Case (IV), the impurity profile of a floating gate electrode is so set that the part of the floating gate electrode covering a drain region and a partial channel region continuous thereto has a low impurity concentration in the conductivity type opposite to that of the drain region, whereas the other part thereof has a high impurity concentration irrespective of the conductivity types.

Regarding the cases (II) and (IV), the $P^-$ region of the floating gate electrode is replaced with an $N^-$ region for a P-channel memory cell.

In the cases (I) and (III), the thinned part of the oxide film is desirably set at a thickness of about 5 nm to about 15 nm, whereas the other part is preferably set at a thickness of about 15 nm to about 100 nm. Besides, in the cases (II) and (IV), it is preferable to set the concentration of the high impurity concentration region at or above about $10^{20}$ cm$^{-3}$ and that of the low impurity concentration region at or below about $10^{19}$ cm$^{-3}$.

In the write operation or erase operation of the memory cell, the electric field which is applied to the gate oxide film is locally modulated in the region where the floating gate electrode overlaps at least either of the drain region and the source region, whereby the generation of a leakage current or the generation or injection of hot carriers can be suppressed, and the performance and reliability of the above operation can be remarkably improved. This is more concretely explained as follows:

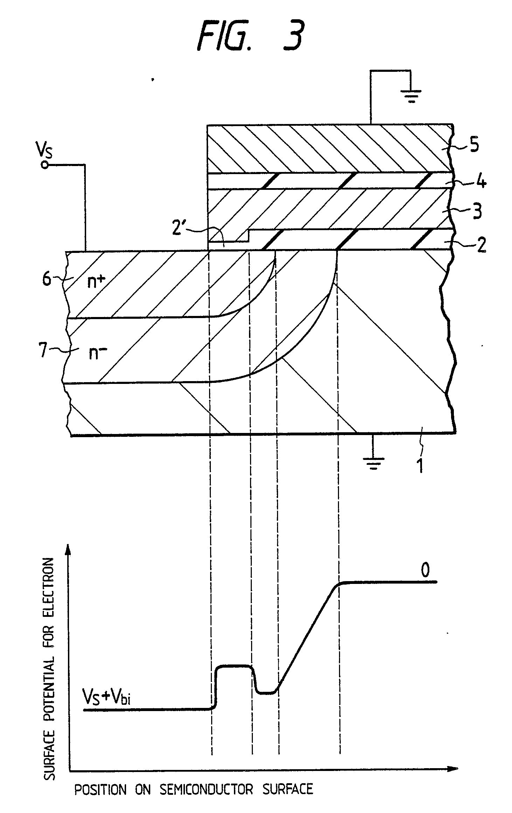

First, according to the expedient of the case (I), even when a positive high voltage is applied to a source junction for the purpose of the erase operation, a surface does not fall into an inverted state under a thick gate oxide film 2 within the overlap region between an $n^+$-type semiconductor region 6 and a floating gate electrode 3, as understood from the graph of a surface potential depicted in Fig. 3. Since the region of the surface functions as an energy barrier to holes, the holes generated under a thin gate oxide film $2'$ can be prevented from flowing out to a p-type semiconductor substrate 1. As a result, a source-substrate leakage current during the erase operation is remarkably reduced, and the power consumption of the erase operation can be lowered. Moreover, since a depletion state under the thin gate oxide film $2'$ is avoided by the storage of the holes, the Fowler-Nordheim tunneling current increases to attain a raised erasing speed, and the injection and capture of the holes into the gate oxide film can be remarkably relieved to heighten the reliability of the erase operation.

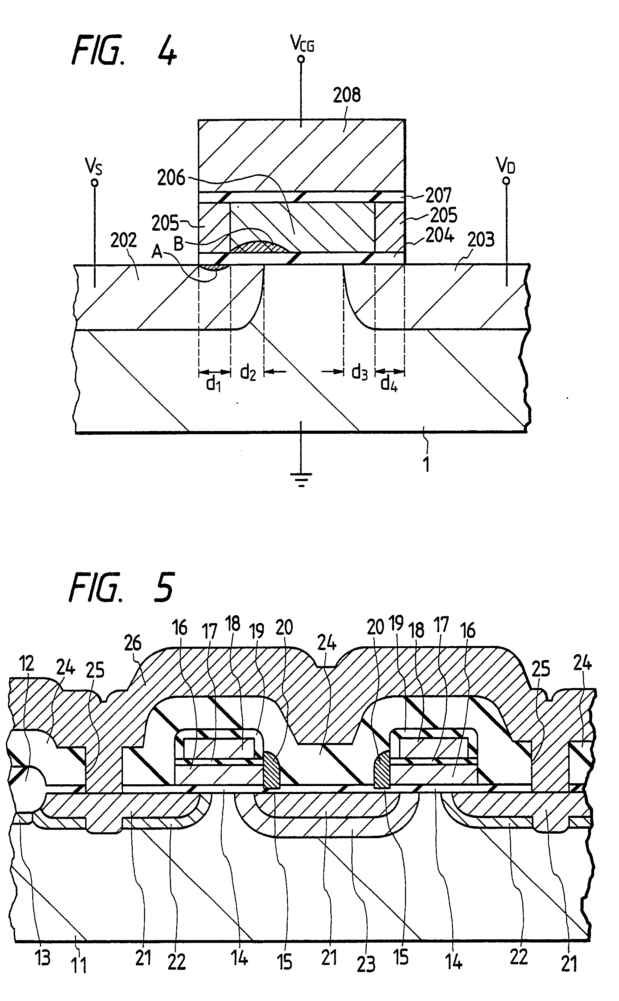

Next, according to the expedient of the case (II), effects similar to those of the case (I) can be produced by utilizing the fact that a depletion layer spreads on the side of a floating gate electrode during the erase operation. More specifically, in a cell constructed as shown in Fig. 4, the voltages of, for example, a source voltage $V_S$ = 12 V, a drain voltage $V_D$ = 0 V or floating, and a control gate voltage $V_{CG}$ = 0 V are applied in the erase operation. On this occasion, a high voltage is applied across a floating gate and a source region 202. Since a region (indicated by $d_1$) sandwiched between the source region 202 and the high concentration region 205 of the floating gate is subjected to an intense electric field, the surface of the source region 202 underlying the floating gate is depleted to give rise to a depletion region A. However, in a region (indicated by $d_2$) sandwiched between the source region 202 and the low concentration region 206 of the floating gate, this low concentration region 206 of the floating gate has a lower impurity concentration and the opposite conductivity type with respect to the source region 202, so that depletion (B) occurs within the low concentration region 206 of the floating gate. Thus, a gate insulator film 204 equivalently thickens to that extent, and a deep depletion layer does not appear in the source region 202. Therefore, the structure of Fig. 4 becomes electrically equivalent to that of Fig. 3, whereby the depletion region A can be made smaller, while holes generated in the deep depletion region A are intercepted by the region $d_2$ and fail to flow into a substrate 201. Accordingly, the source-substrate leakage current illustrated in Fig. 1 can be eliminated.

Owing to the elimination of the source-substrate leakage current, the holes generated in the region A have nowhere to go and concentrate to the side of the gate insulator film 204. As a result, the application of the voltage to the gate insulator film 204 narrows the region A and simultaneously brings forth the advantage of increase in the FN tunneling current. Important here is that the source region 202 is diffused so as to extend laterally inside the high concentration region 205 of the floating gate (that $d_2$ > 0 holds). Besides, the impurity concentration of the low concentration region 206 is set at, at most, $10^{19}$ cm$^{-3}$ in order to make the width of the depletion layer at least 10 nm.

According to the expedient of the case (III), electric field concentration at the edge part of a drain region is moderated in a drain disturb state at the cutoff of a channel. In addition, the electric field of a gate oxide film overlying the drain region can be weakened. On the other hand, an electric field appearing at the edge part of the drain region is intensified contrariwise in a write operation state. As a result, when a programming voltage is applied only to the drain regions, the suppression of the drain disturb phenomenon and the enhancement of a writing efficiency are simultaneously realized.

Moreover, since the part of the gate oxide film other than the part thereof on the side of the drain region is not thickened, the electrically erasing function is not spoilt. Further, the above effects can be produced without decrease in a read current in such a way that the width of the part of the gate oxide film to be thickened on the channel region is made smaller than the width of a depletion layer which spreads from a drain junction into the channel region.

According to the expedient of the case (IV), effects similar to those of the case (III) can be attained by utilizing the fact that a depletion layer spreads in the low concentration region of a floating gate electrode on the side of a drain region when a programming voltage is applied only to the drain regions.

As thus far described, according to the present invention, it is possible to realize with a cell area nearly equal to that of an ultraviolet-erased EPROM memory cell, a floating-gate nonvolatile memory cell the consumptive power of which is low and which is capable of electrical write and erase operations of high performance and high reliability. The cells of the invention make it possible to construct a memory chip which can be electrically rewritten, at a density of integration comparable to that of an ultraviolet-erased EPROM.

## Brief Description of the Drawings

Fig. 1 is a view for explaining the generation mechanism of a junction leakage current during an erase operation in a prior-art structure;

Fig. 2 is a diagram for explaining expedients for solving problems as form the present invention;

Figs. 3 and 4 are views for explaining the mechanisms of reducing junction leakage currents in erase operations according to the present invention;

Fig. 5 is a sectional view of memory cells in Embodiment 1 of the present invention;

Fig. 6 is a plan view of the memory cells in Embodiment 1 of the present invention;

Fig. 7 is an equivalent circuit diagram of a memory cell array in Embodiment 1 of the present invention;

Figs. 8 thru 19 are views illustrative of a process for manufacturing the memory cells in Embodiment 1 of the present invention;

Fig. 20 is a sectional view of memory cells in Embodiment 2;

Fig. 21 is a plan view of the memory cells in Embodiment 2;

Figs. 22 thru 30 are sectional views of the memory cells in a process for manufacturing Embodiment 2;

Fig. 31 is a sectional view of memory cells in Embodiment 3;

Fig. 32 is a sectional view of memory cells in Embodiment 4; and

Figs. 33 and 34 are sectional views of a memory cell in Embodiment 5.

## Description of the Preferred Embodiments

(Embodiment 1)

Now, the first embodiment of the present invention will be described with reference to Fig. 5 thru Fig. 19. This embodiment corresponds to the case (I) of the expedient for solving the problems.

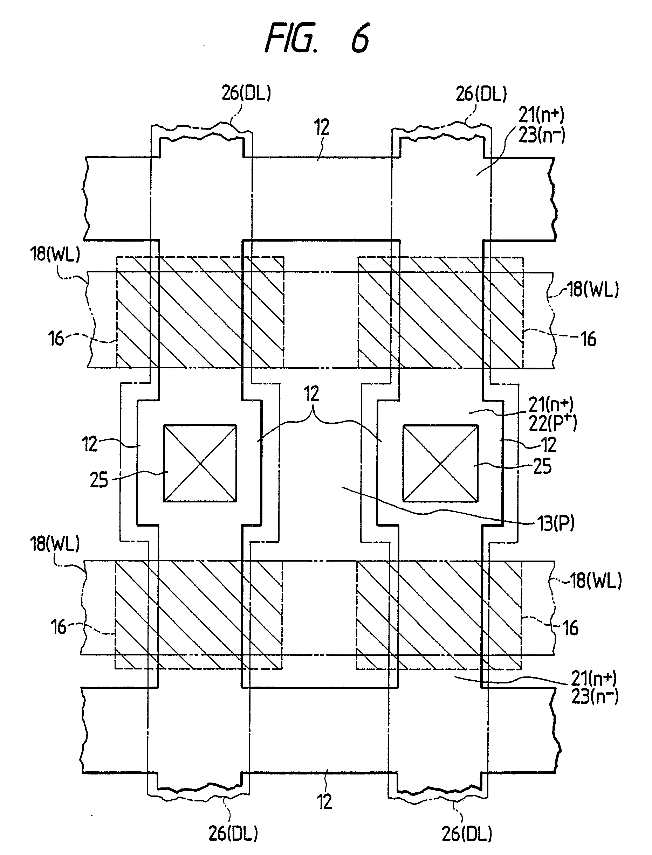

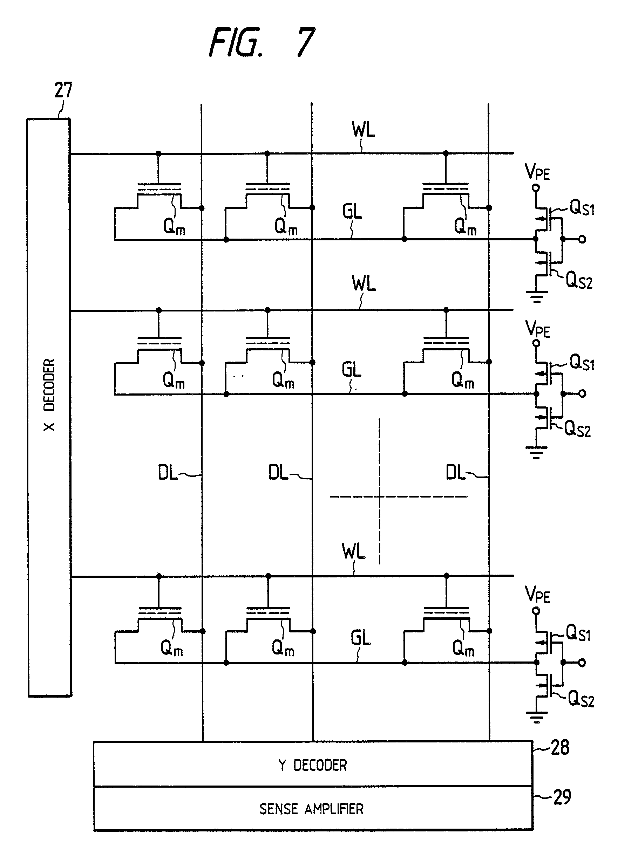

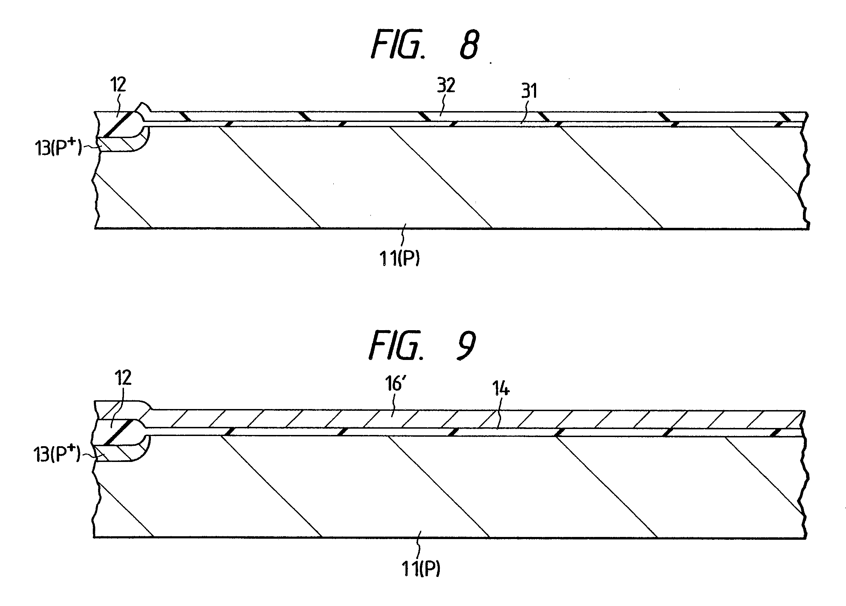

Fig. 5 is a sectional view of 2 bits of memory cells in this embodiment, Fig. 6 is a plan view of the memory cells (4 bits), Fig. 7 is an equivalent circuit diagram of a memory cell array employing the memory cells, and Figs. 8 thru 19 are sectional views of the same portion as in Fig. 5 at the steps of manufacturing the memory cells. By the way, in Fig. 6, insulator films except a field insulator film are not shown for the brevity of the illustration of the construction of the memory cells.

First, referring to Fig. 7, the operations of a memory cell array circuit will be outlined.

In Fig. 7, numeral 27 designates an X-decoder, numeral 28 a Y-decoder, and numeral 29 a sense amplifier. Symbol $Q_m$ denotes a memory cell, which is constructed of a MISFET having a floating gate electrode and a control gate electrode. The control gate electrode is connected to a word line WL. Besides, a drain region is connected to a data line DL, and a source region to a ground line GL. Symbols $Q_{s1}$ and $Q_{s2}$ denote switching elements which serve to apply the ground potential of circuitry, for example, 0 V to the ground line GL in the modes of writing and reading information and to apply an erase potential $V_{PE}$, for example, 12 V in the mode of erasing information. In the modes of writing and reading information, the element $Q_{s2}$ is brought into the conductive state thereof, and the element $Q_{s1}$ is brought into the nonconductive state thereof. In the mode of erasing information, the element $Q_{s1}$ is brought into the conductive state and the element $Q_{s2}$ into the nonconductive state to the contrary. The data line DL is supplied with a write potential $V_{PW1}$ (for example, 6 V) in the write mode, and with a read potential (for example, 1 V) in the read mode. In the erase mode, it is supplied with the ground potential $V_{SS}$ (for example, 0 V) or a low voltage of at most about 2 V, or it is put in the floating state thereof. The word line WL is supplied with a write potential $V_{PW2}$ (for example, 12 V) in the write mode, and with a power source potential $V_{CC}$ (for example, 5 V) in the read mode. It is supplied with the ground potential $V_{SS}$ (for example, 0 V) in the erase mode.

Next, the structure and features of the memory cell according to this embodiment will be described with reference to Figs. 5 and 6.

As shown in Figs. 5 and 6, the MISFET being the memory cell is constructed of a thick gate oxide film 14 and a thin gate oxide film (tunneling oxide film) 15 which are formed on the principal surface side of a p-type semiconductor substrate 11, a floating gate electrode 16, an inter-layer oxide film 17, a control gate electrode 18, a side-wall protective oxide film 19 for the control gate electrode a side-wall type floating gate electrode 20 which is connected to the floating gate electrode 16, $n^+$-type semiconductor regions 21, a $p^+$-type semiconductor region 22, and an $n^-$-type semiconductor region 23.

Both the gate oxide films 14 and 15 are made of silicon oxide which is produced by oxidizing the surface of the semiconductor substrate 11, and the thin portion 15 has a thickness of about 10 nm, while the thick portion 14 has a thickness of about 35 nm. The thin gate oxide film 15 is overlaid with the side-wall type floating gate electrode 20, and this region functions as the tunneling region of electrons. The side-wall type floating gate electrode 20 has a length of about 0.15 $\mu$m in the lengthwise direction of a channel.

The inter-layer oxide film 17 is made of a silicon oxide film which is produced by the oxidization of the surface of a polycrystalline silicon film being the floating gate electrode 16, and it has a thickness of about 20 - 30 nm. The control gate electrode 18 is made of, for example, a second layer of polycrystalline silicon film and is deposited on the surface of the inter-layer oxide film 17. In addition, it is formed to be integral with the word line WL and is extended on a field insulator film 12. Since the control gate electrode 18 has at least its side wall part covered with the side-wall protective oxide film 19, it is not short-circuited by the side-wall type floating gate electrode 20.

A drain region is formed of the $n^+$-type semiconductor region 21, which is connected to the aluminum data line 26 through a contact hole 25. The $n^+$-type semiconductor region 21 has a junction depth of about 0.3 $\mu$m except its part underneath the contact hole 25.

The $p^+$-type semiconductor region 22 is formed so as to cover the drain region, thereby to realize the prevention of punch-through during an erase operation and the enhancement of the injection efficiency of channel hot electrons during a write operation. The $p^+$-type semiconductor region 22 has a concentration of about 5 x $10^{17}$ cm$^{-3}$ at

its junction plane with the $n^+$-type semiconductor region 21, and it spreads down to a depth of about 0.4 - 0.5 $\mu$m.

A source region is formed of the $n^+$-type semiconductor region 21 and the $n^-$-type semiconductor region 23. The $n^+$ $n^-$ semiconductor regions 21 and 23 constituting the source region extend in the extending direction of the word line WL and define the ground line GL between the two memory cells which are connected to the identical aluminum data line 26 through two adjacent contact holes 25.

The junction depth of this $n^+$-type semiconductor region 21 is about 0.3 $\mu$m as in the case of the drain region. The thin gate oxide region 15 to function as the tunneling region of the electrons is entirely underlaid with the $n^+$-type semiconductor region 21.

The $n^-$-type semiconductor region 23 is provided so as to intervene between the $n^+$-type semiconductor region 21 and the p-type semiconductor substrate 11, and it functions to heighten the breakdown voltage of a source junction. The concentration of the $n^-$-type semiconductor region 23 is about 1 x $10^{19}$ cm$^{-3}$ at the boundary thereof with the $n^+$-type semiconductor region 21, and the junction depth thereof is about 0.5 $\mu$m. The junction breakdown voltage on this occasion exceeds 17 V easily.

Numeral 24 indicates an insulator film which is made of, for example, a phosphosilicate glass (PSG) and which covers the principal surface of the p-type semiconductor substrate 11. The selected part of the insulator film 14 on the $n^+$-type semiconductor region 21 constructing the drain region is removed, thereby to form the contact hole 25. The data line 26 made of the aluminum film is connected through this contact hole 25 to the $n^+$-type semiconductor region 21 constructing the drain region. The junction depth of the part of this $n^+$-type semiconductor region underneath the contact hole 25 is greater than that of the other part.

By the way, although not shown in Fig. 5, a protective film which consists of, for example, a PSG film formed by CVD and a silicon nitride film formed thereon covers the aluminum data lines 26.

The operations of writing, erasing and reading information into/from the memory cell are respectively performed by applying the voltages already explained in Fig. 7 to the corresponding regions. In the write operation, among hot carriers generated in the channel side edge part of the $n^+$-type semiconductor region 21 of the drain region, some of hot electrons are injected into the floating gate electrode 16, so that the threshold voltage of the memory transistor as viewed from the control gate electrode 18 rises. In the erase operation, the electrons held in the floating gate electrode 16 are emitted into the $n^+$-type semiconductor region 21 being a part of the source region through the thin gate oxide film 15 on the basis of the Fowler-Nordheim tunneling, so that the threshold voltage as viewed from the control gate electrode 18 lowers. Besides, the read operation is carried out by detecting the discrepancy of the threshold voltages as the difference of channel currents. Incidentally, a control circuit for automatic erase stop, according to which an erase voltage is automatically brought down when the threshold voltage of the memory transistor has become about 1 V in the erase operation, is provided in on-chip fashion, whereby the memory cell of the one-transistor/bit type can be realized.

Next, a method of manufacturing the memory cell will be described with reference to Figs. 8 thru 19.

As illustrated in Fig. 8, a silicon oxide film 31 is grown on the principal surface of a p-type semiconductor substrate 11 by thermal oxidation. Thereafter, using as a thermal oxidation mask a silicon nitride film 32 produced by, for example, CVD, the predetermined part of the surface of the semiconductor substrate 11 is oxidized to form a field oxide film 12. A $p^+$-type channel stopper 13 is formed in such a way that, before the formation of the field oxide film 12, a p-type impurity, for example, boron (B) is introduced by ion implantation. After the formation of the field insulator film 12, the silicon nitride film 32 and the silicon oxide film 31 are removed.

Subsequently, as illustrated in Fig. 9, the surface of the semiconductor substrate 11 exposed outside the field insulator film 12 is oxidized, thereby to form a thick gate oxide film 14 which is made of a silicon oxide film having a thickness of about 35 nm. On the resultant substrate, a polycrystalline silicon film 16' to be patterned as a floating gate electrode later is formed by, for example, CVD. The thickness of this film 16' is set at about 200 nm. An n-type impurity, for example, phosphorus (P) is introduced into the polycrystalline silicon film 16' by thermal diffusion, ion implantation or the like.

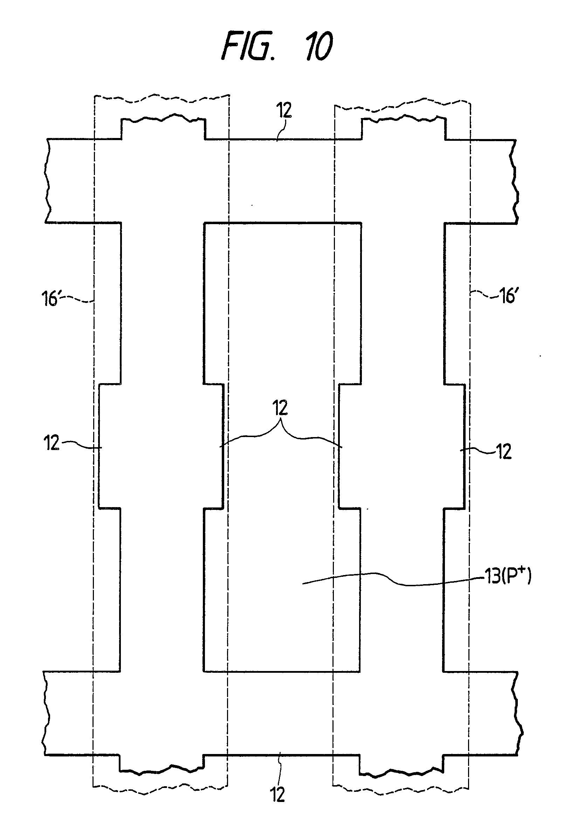

Subsequently, as illustrated in Fig. 10, the polycrystalline silicon film 16' is patterned so as to extend in the extending direction of data lines with the predetermined width of the floating gate electrodes 16, by etching which employs a resist film. After the patterning, an etching mask made of the resist film is removed.

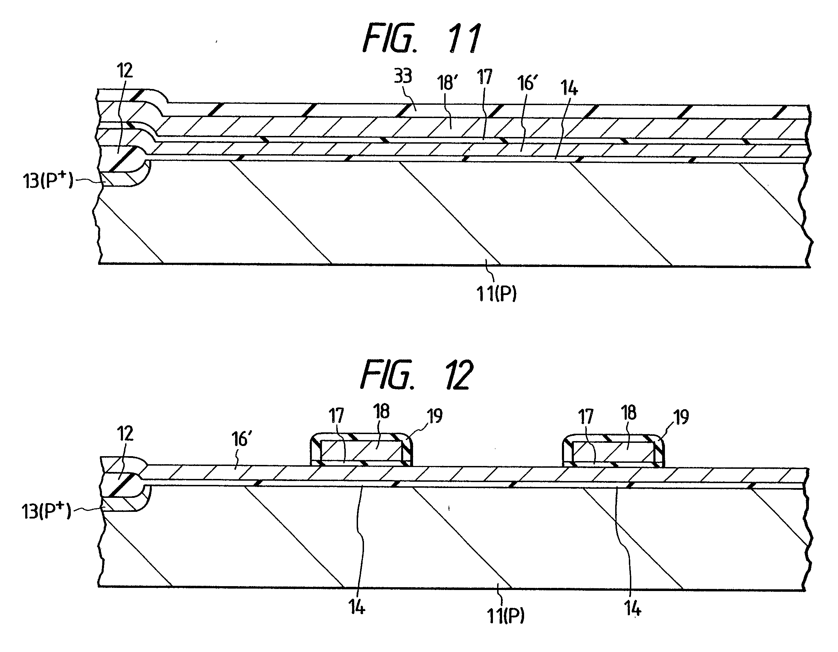

At the next step, as illustrated in Fig. 11, the surface of the polycrystalline silicon film 16' is oxidized to form an inter-layer oxide film 17 which is made of a silicon oxide film. The thickness of this film 17 is set at about 20 - 30 nm. Subsequently, in order to form control gate electrodes 18 and word lines WL, a polycrystalline silicon film 18'

having a thickness of about 350 nm is formed on the whole surface of the semiconductor substrate 11 by, for example, CVD. An n-type impurity, for example, phosphorus (P) is introduced into the polycrystalline silicon film 18' by thermal diffusion, ion implantation or the like. Subsequently, a silicon oxide film 33 having a thickness of about 150 nm is formed by, for example, CVD.

Next, as illustrated in Fig. 12, using a mask made of a resist film, the silicon oxide film 33 and the polycrystalline silicon film 18' are continuously patterned by etching, thereby to form the control gate electrodes 18 and the word lines WL. After the resist mask is removed, a silicon oxide film having a thickness of about 50 nm is formed by, for example, CVD. Subsequently, using the technique of reactive ion etching (RIE), this silicon oxide film and the inter-layer oxide film 17 are etched until the surface of the polycrystalline silicon film 16' is exposed, whereby side-wall protective oxide films 19 are selectively formed on the side surfaces of the control gate electrodes 18. At this time, a part of the silicon oxide film 33 remains on each control gate electrode 18. Hereinbelow, the silicon oxide film surrounding the control gate electrode 18 as includes the remaining silicon oxide film 33 shall be termed the "side-wall protective oxide film 19."

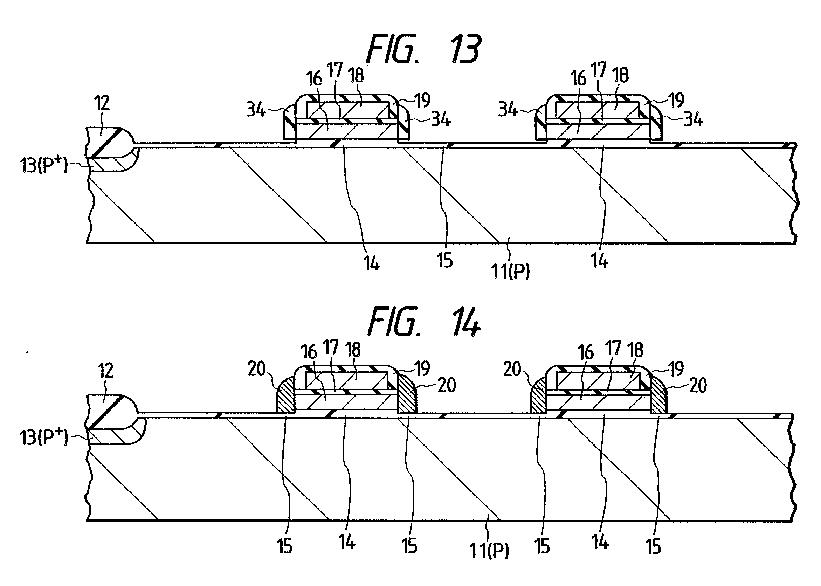

Next, as illustrated in Fig. 13, using as a mask the control gate electrodes 18 and the side-wall protective oxide films 19 covering them, the polycrystalline silicon film 16' is etched to form the floating gate electrodes 16. Subsequently, a silicon nitride film having a thickness of 50 nm is formed by, for example, CVD and is subjected to reactive ion etching, thereby to form side-wall protective nitride films 34 which protect the side surfaces of the floating gate electrodes 16. Subsequently, the thick gate oxide film 14 exposed on the surface of the semiconductor substrate 11 is removed by wet etching, and the surface of the substrate is thermally oxidized again, thereby to grow a thin gate oxide film 15 having a thickness of about 10 nm. After the thermal oxidation, the side-wall protective nitride films 34 are removed with hot phosphoric acid.

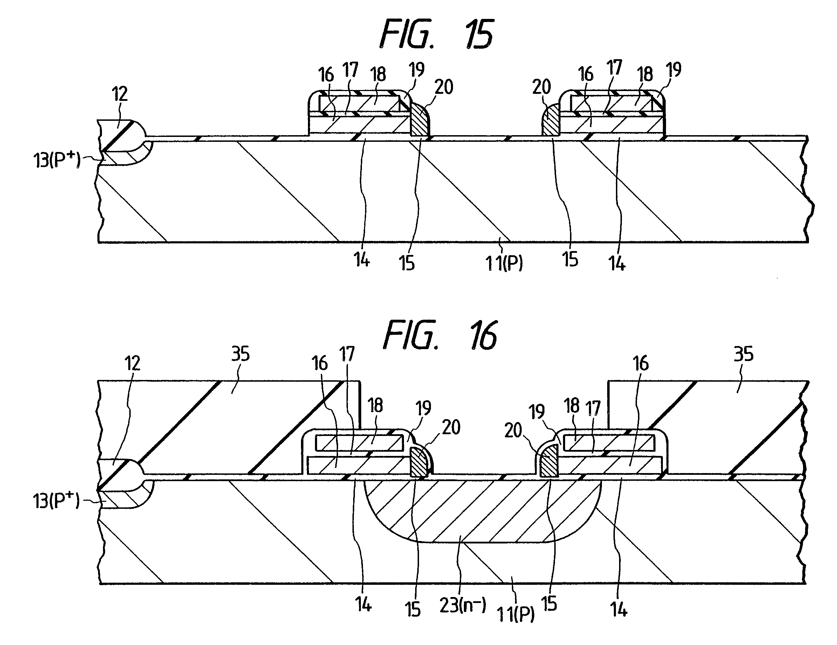

Next, as illustrated in Fig. 14, a polycrystalline silicon film having a thickness of about 150 nm is formed by, for example, CVD and has an n-type impurity, for example, phosphorus (P) introduced thereinto, and it is thereafter etched by reactive ion etching until the underlying silicon oxide films 15 and 19 are exposed, whereby side-wall type floating gate electrodes 20 are formed. The side-wall type floating gate electrode 20 lies in contact with the floating gate electrode 16 already formed, at the side surface thereof, and both the electrodes function as information charge-holding portion unitarily. The length of the side-wall type floating gate electrode 20 in the lengthwise direction of a channel becomes about 0.15 μm which is equal to the very thickness of the deposited film.

To be noted here is that, at the stage of Fig. 14, the side-wall type floating gate electrode 20 is formed to be continuous along the steps of the word line WL (even in places which are not underlaid with the floating gate electrodes 16), so that the floating gate electrodes of all the memory cells connected to one word line are short-circuited by the side-wall type floating gate electrode 20. In addition, the side-wall type floating gate electrode is formed even on a drain side on which it is not required for the electrical erase operation.

As illustrated in Fig. 15, therefore, the unnecessary parts of the side-wall type floating gate electrodes 20 are removed by wet etching which employs a mask made of a resist film. By the above steps, tunneling regions for electrons in which the gate oxide film is locally thin can be formed at the edge parts of the floating gate electrodes on the sides of source junctions, in self-alignment fashion.

At the next step, as illustrated in Fig. 16, the surfaces of the side-wall type floating gate electrodes 20 and the semiconductor substrate 11 are thermally oxidized about 20 nm, whereupon a mask 35 for forming an $n^-$-type semiconductor region as made of a resist film is formed. Subsequently, by ion implantation employing this mask, an n-type impurity, for example, phosphorus (P) is introduced into the exposed surface part of the semiconductor substrate 11 at a dose of approximately $1 \times 10^{14}$ - $5 \times 10^{14}$ atoms/cm², thereby to form the $n^-$-type semiconductor region 23. After the removal of the resist film 35, the $n^-$-type semiconductor region 23 may well be stretched by a heat treatment at a high temperature.

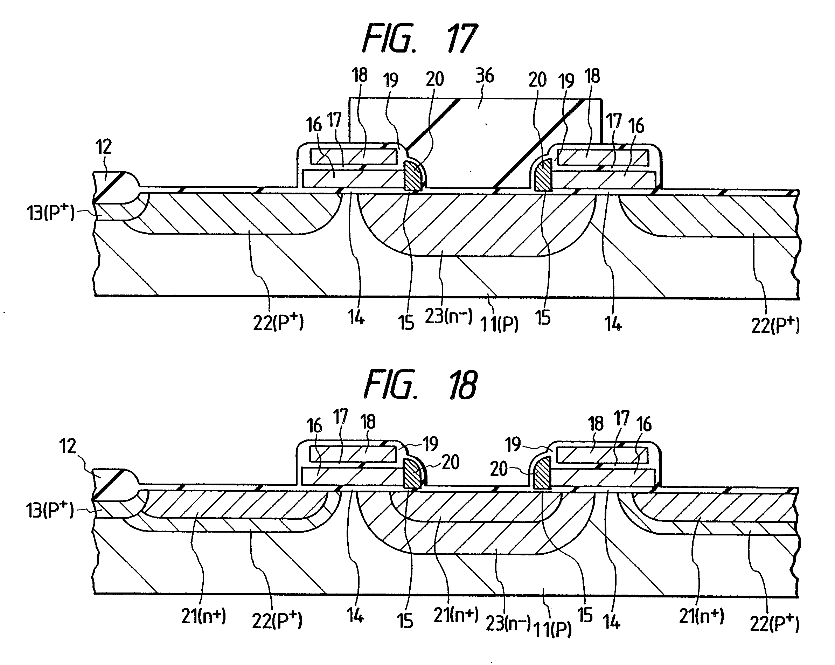

Next, as illustrated in Fig. 17, a mask 36 for forming $p^+$-type semiconductor regions as made of a resist film is formed. Subsequently, by ion implantation employing this mask, a p-type impurity, for example, boron (B) is introduced into the exposed surface parts of the semiconductor substrate 11 at a dose of approximately $5 \times 10^{13}$ - $1 \times 10^{14}$ atoms/cm², thereby to form the $p^+$-type semiconductor regions 22. After the removal of the resist film 36, the $p^+$-type semiconductor regions 22 may well be stretched by a heat treatment at a high temperature.

Next, as illustrated in Fig. 18, using the floating gate electrodes 16, control gate electrodes 18 and side-wall type floating gate electrodes 20 as a mask, an n-type impurity, for example, arsenic (As) is introduced into the surface of the semiconductor substrate 11 at a dose of approximately $2 \times 10^{15}$ - $5 \times 10^{15}$ cm⁻² by ion implantation, whereby $n^+$-type semiconductor regions 21 are formed. Subsequently, the crystallinity recovery and drive-in diffusion of the $n^+$-type semiconductor regions 21 are performed by annealing in order that the $n^+$-type semiconductor region 21 may be extended under the thick gate oxide film 14 beyond the tunneling region of the thin gate oxide film 15.

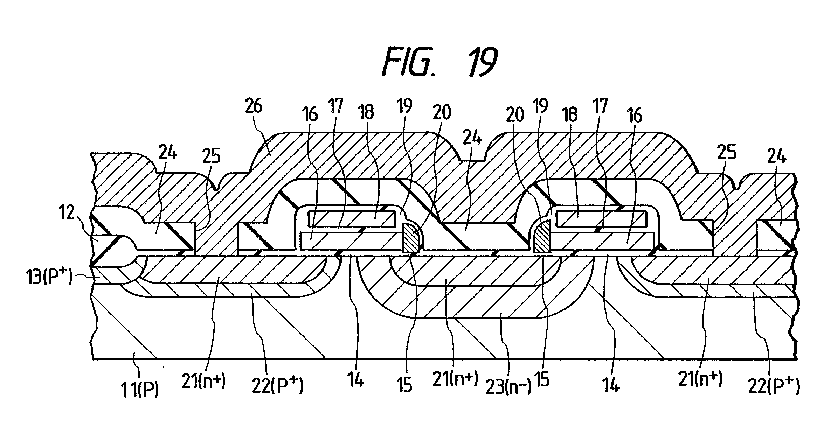

Subsequently, as illustrated in Fig. 19, an insulator film 24 made of a PSG film is formed on the whole surface of the resultant semiconductor substrate 11 by, for example, CVD. Thereafter, contact holes 25, a data line 26 made of an aluminum film, and a final passivation film not shown are formed. Then, the manufacturing process of the memory cell ends.

According to this embodiment described above:

(1) The region of a tunneling oxide film for drawing out electrons from a floating gate electrode can be provided at the edge part of the electrode nearer to a source region in self-alignment fashion.

(2) Since a gate oxide film is thick at the edge part of an $n^+$-type semiconductor region constituting the source region, a source-substrate leakage current during an erase operation (when a positive high voltage is applied to the source region) can be suppressed to or below $10^{-10}$ A per cell.

Moreover, in relation to the reduction of the leakage current, the injection of hot holes into the tunneling oxide film is remarkably suppressed, so that the stability and reliability of erasing characteristics can be improved.

(Embodiment 2)

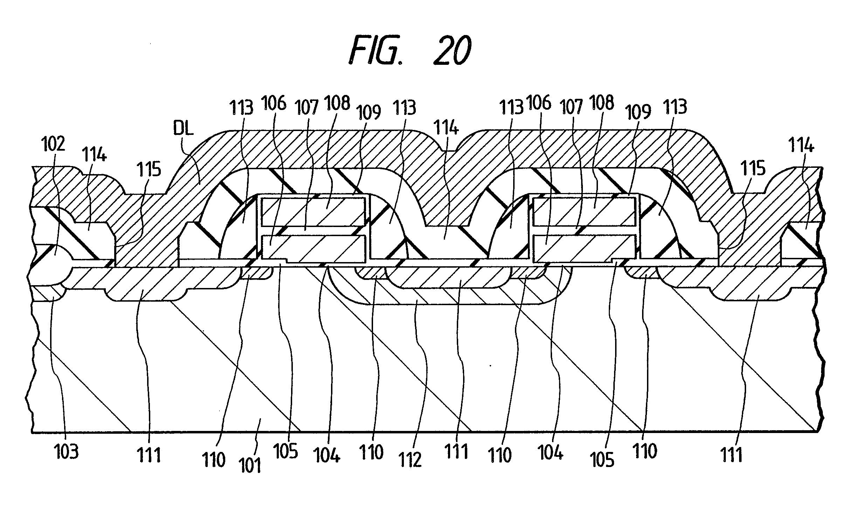

Now, the second embodiment of the present invention will be described with reference to Figs. 20 - 30. This embodiment corresponds to the case (III) of the expedient for solving the problems.

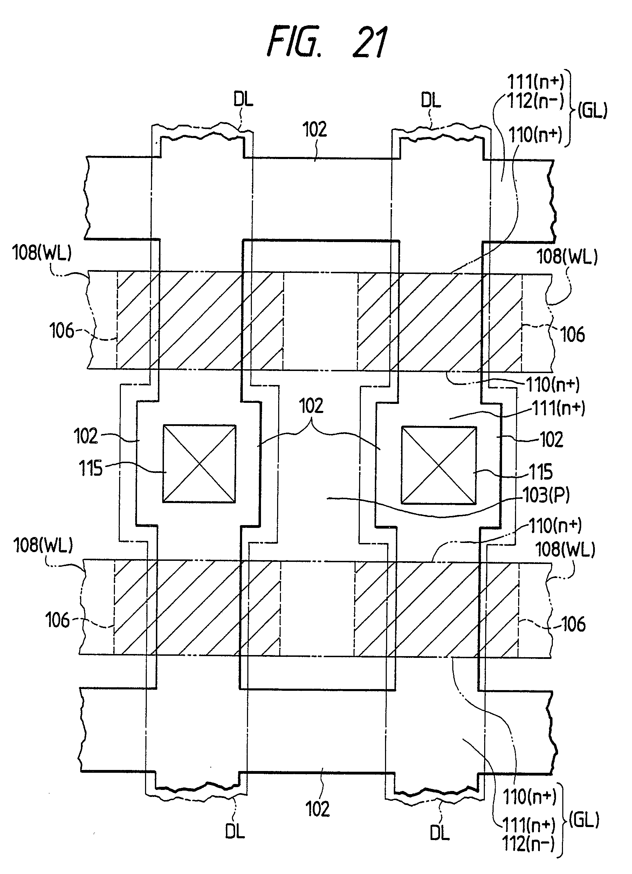

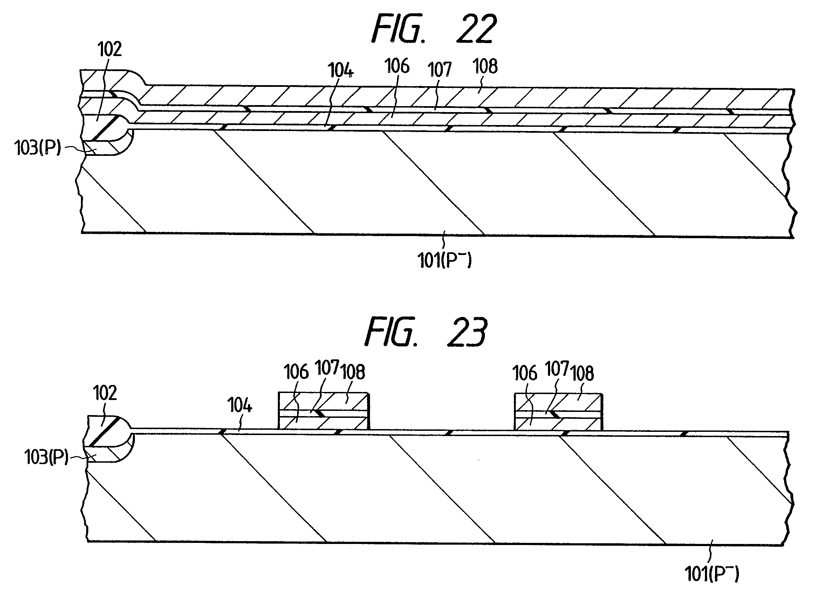

Fig. 20 is a sectional view of 2 bits of memory cells in this embodiment, Fig. 21 is a plan view of the memory cells (4 bits), and Figs. 22 thru 30 are sectional views of the same portion as in Fig. 20 at the steps of manufacturing the memory cells.

First, referring to Figs. 20 and 21, the structure and features of the memory cell according to the present invention will be explained.

As shown in Figs. 20 and 21, a MISFET being a memory cell is constructed of a thin gate insulator film 104, a thick gate insulator film 105, a floating gate electrode 106, an inter-layer dielectric or insulator film 107, a control gate electrode 108, $n^+$-type semiconductor regions 110, $n^-$-type semiconductor regions 111, and an $n^-$-type semiconductor region 112.

Both the gate oxide films 104 and 105 are made of silicon oxide which is produced by oxidizing the surface of a semiconductor substrate 101, and the thin portion 104 has a thickness of about 10 nm, while the thick portion 105 has a thickness of about 20 nm. The thick portion 105 extends about 0.3 $\mu$m in the lengthwise direction of a channel from the end part of the gate electrode nearer to a drain region. As will be stated later, the part of the drain region underlying the floating gate electrode 106 is entirely covered with the thick gate insulator film 105.

The inter-layer insulator film 107 is made of a silicon oxide film formed by the oxidation of the surface of a polycrystalline silicon film being the floating gate electrode 106, and it has a thickness of about 20 - 30 nm. The control gate electrode 108 is made of a polycrystalline silicon film of, for example, the second layer, and it is deposited on the surface of the inter-layer insulator film 107. Besides, it is formed unitarily with a word line WL and is extended on a field insulator film 102.

The drain region is constructed of the $n^+$-type semiconductor region 110 and the $n^+$-type semiconductor region 111, and is connected to a data line DL through a contact hole 115. In the drain region, the edge part thereof nearer to the channel region is constructed of the shallow $n^+$-type semiconductor region 110 having a junction depth of about 0.2 $\mu$m. Therefore, the extension of the drain region underneath the floating gate electrode 106 is short. In addition, the thick gate insulator film 105 at the edge part of the gate electrode nearer to the drain region covers the extended part of the drain region and further spreads the channel region. The overlap of the thick gate insulator film 105 and the channel region in the channel length direction is about 0.1 $\mu$m.

The length of the $n^+$-type semiconductor region 110 in the channel length direction is defined by a side-wall spacer 113 which is made of a silicon oxide film. The part of the drain region spaced from the channel region is made of the $n^+$-type semiconductor region 111 which has a comparatively great junction depth of about 0.3 $\mu$m.

A source region is constructed of the $n^+$-type semiconductor region 110, the $n^+$-type semiconductor region 111 and the $n^-$-type semiconductor region 112. The $n^+$-type semiconductor regions 110, 111 and $n^-$-type semiconductor region 112 which constitute the source region extend in the extending direction of the word line WL between two memory cells which are connected to the identical data line DL through two adjacent contact holes 115, whereby they construct a ground line GL. In the source region, the edge part thereof nearer to the channel region is constructed of the shallow $n^+$-type semiconductor region 110 having a junction depth of about 0.2 $\mu$m, likewise to the case of the drain region. As a result, the extension the edge part underneath the floating gate electrode 106 is short, and the capacitance between the source region and the floating gate electrode 106 is reduced. The length of this $n^+$-type semiconductor region 110 in the channel length direction is defined by a side-wall spacer 113 as in the case of the drain region.

The surface portion of the part of the source region spaced from the channel region is made of the $n^+$-type semiconductor region 111 having a great junction depth. Further, the $n^-$-type semiconductor region 112 is interposed between the $n^+$-type semiconductor region 110 as well as the $n^+$-type semiconductor region 111 and the semiconductor substrate 101. This $n^-$-type semiconductor region 112 reaches the surface of the semiconductor substrate 101 within the channel region. Therefore, the junction breakdown voltages between the $n^+$-type semiconductor regions 110, 111 and the semiconductor substrate 101 are heightened.

A silicon oxide film 109 is deposited so as to cover the surface parts of the semiconductor substrate 101 exposed from the field insulator film 102 and floating gate electrode 106 and also the exposed surfaces of the floating gate electrode 106 and control gate electrode 108. The side-wall spacers 113 made of silicon oxide films are deposited on the parts of the silicon oxide film 109 corresponding to the side surfaces of the floating gate electrode 106 and control gate electrodes 108.

Numeral 114 indicates an insulator film which is made of, for example, a phosphosilicate glass (PSG) film and which covers the semiconductor substrate 101. The part of the insulator film 114 which overlies the $n^+$-type semiconductor region 111 constituting the drain region is selectively removed, thereby to form the contact hole 115. The data line DL made of an aluminum film is connected through this contact hole 115 to the $n^+$-type semiconductor region 111 constituting the drain region. The part of the $n^+$-type semiconductor region 111 connected to the data line DL has a junction depth greater than that of the other part thereof. By the way, although not shown in Fig. 20, a protective film which is formed of, for example, a PSG film produced by CVD and a silicon nitride film deposited thereon covers the data lines DL.

The operations of writing, erasing and reading information into/from the memory cell are the same as in the first embodiment, and they are respectively performed by applying the voltages already elucidated in Fig. 7 to the corresponding regions.

Now, a method of manufacturing the memory cell will be described. Since the steps of Figs. 8 - 10 in the manufacturing method of the first embodiment hold quite true, the ensuing steps will be explained here. Reference will be had to Figs. 22 - 30.

As illustrated in Fig. 22, the surface of a polycrystalline silicon film 106, which is provided on the principal surface of a $p^-$-type semiconductor substrate 101 through a thin gate oxide film 104 having a thickness of about 10 nm, is oxidized to form an inter-layer insulator film 107 made of a silicon oxide film. The thickness of this film 107 is set at about 20 - 30 nm. The gate insulator films of MISFETs which constitute peripheral circuits such as address buffer circuits, decoder circuits and sense amplifiers are simultaneously formed by the step of oxidation. Subsequently, a polycrystalline silicon film 108 is formed on the whole surface of the resultant semiconductor substrate 101 by, for example, CVD in order to form control gate electrodes 108 and word lines WL. An n-type impurity, for example, phosphorus (P) is introduced into the polycrystalline silicon film 108 by thermal diffusion, ion implantation or the like.

Subsequently, as illustrated in Fig. 23, the polycrystalline silicon film 108 is patterned by etching with a mask made of a resist film, thereby to form the control gate electrodes 108 and word lines WL. At the etching step, also the gate electrodes of the MISFETs constituting the peripheral circuits are simultaneously formed. In succession to the above etching, the parts of the inter-layer insulator film 107 exposed from the control gate electrodes 108 are etched. Further, the polycrystalline silicon film 106 is etched to form floating gate electrodes 106. After the series of etching steps, the etching mask made of the resist film is removed. Incidentally, each of the control gate electrodes 108, word lines WL, and gate electrodes of the MISFETs of the peripheral circuits may be made of a film of refractory metal such as Mo, W, Ta or Ti or any silicide thereof or may well be a double-layer film in which the film of the refractory metal or the silicide thereof is stacked on a polycrystalline silicon film.

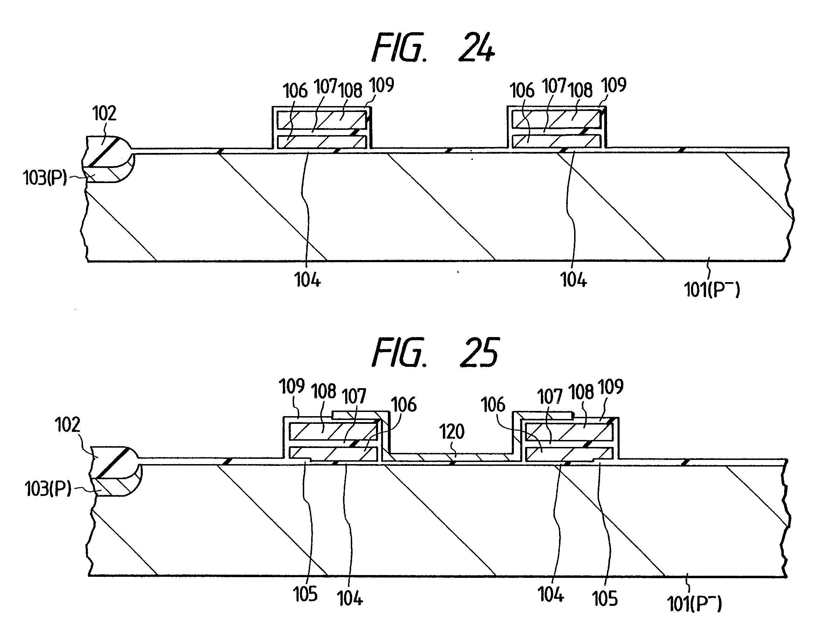

Subsequently, as illustrated in Fig. 24, the exposed surfaces of the floating gate electrodes 106 and control gate electrodes 108 (word lines WL) are lightly oxidized to form silicon oxide films 109.

Subsequently, as illustrated in Fig. 25, the predetermined parts of the surface of the semiconductor substrate 101 and the upper and side surfaces of the floating gate electrodes 106 and control gate electrodes 108 are oxidized using as a thermal oxidation mask a silicon nitride film 120 produced by, for example, CVD. On this occasion, by employing wet oxidation at a comparatively low temperature, the oxidation proceeds in the channel length direction from the end parts of the gate electrodes not covered with the silicon nitride film 120, and thick gate oxide films 105 each having a thickness of about 20 nm are formed. The spread of the region of each thick gate oxide film 105 in the channel length direction is set at about 0.3 $\mu$m.

Regarding the inter-layer insulator film 107, a thick region is similarly formed, but it is not depicted here. After the thermal oxidation, the silicon nitride film 120 is removed.

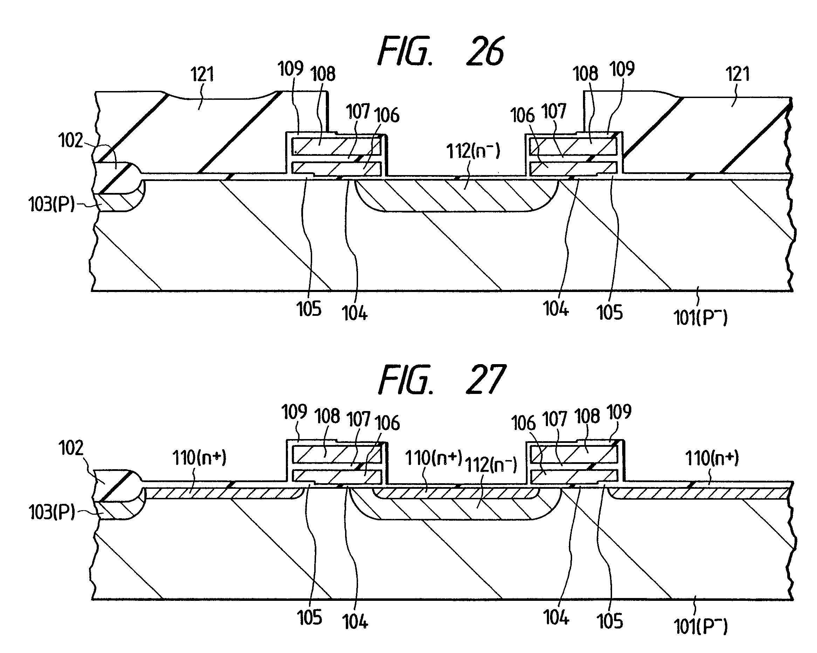

At the next step, as illustrated in Fig. 26, a mask 121 for forming an $n^-$-type semiconductor region 112 as made of a resist film is formed on the semiconductor substrate 101. The mask 121 also covers the regions of the peripheral circuits. Subsequently, an n-type impurity, for example, phosphorus (P) is introduced into the exposed surface part of the semiconductor substrate 101 at a dose of approximately $5 \times 10^{13} - 5 \times 10^{14}$ atoms/cm$^2$ by ion implantation, thereby to form the $n^-$-type semiconductor region 112. After the ion implantation, the mask 120 is removed. Thereafter, the $n^-$-type semiconductor region 112 may well be driven in by annealing so as to have a junction depth greater than that of $n^+$-type semiconductor regions 110 which are to be formed later.

Next, as illustrated in Fig. 27, using the floating gate electrodes 106 and control gate electrodes 108 as a mask, an n-type impurity, for example, arsenic (As) is introduced into the surface of the semiconductor substrate 101 at a dose of $2 - 5 \times 10^{15}$ atoms/cm$^2$ by the ion implantation, whereby the $n^+$-type semiconductor regions 110 are formed. By the way, at this step of ion implantation, ions are implanted into only the memory cell region by covering the peripheral circuit regions with a mask made of resist films, and further, an n-type impurity, for example, phosphorus (P) is introduced into the peripheral circuit regions at a dose of approximately $1 \times 10^{13}$ atoms/cm$^2$ by ion implantation in which the memory cell region is covered with another mask made of a resist film, whereby the source and drain regions of the N-channel MISFETs constituting the peripheral circuits can also be brought to LDD (Lightly Doped Drain) structures. In this case, any of the masks made of the resist films is removed after the corresponding ion implantation.

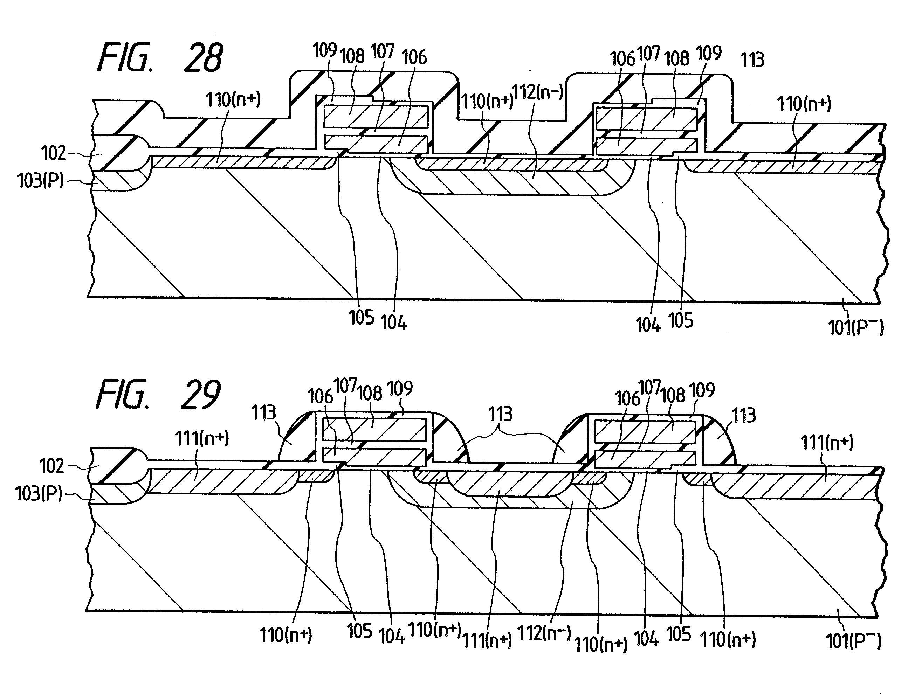

Next, as illustrated in Fig. 28, a silicon oxide film 113 for forming side-wall spacers 113 is formed on the whole surface of the resultant semiconductor substrate 101 by, for example, CVD.

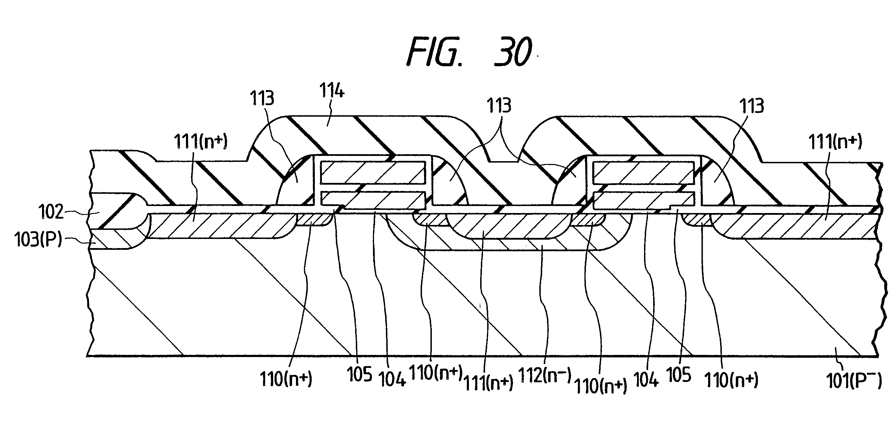

Next, as illustrated in Fig. 29, the silicon oxide film 113 is etched by reactive ion etching (RIE) until the surface of the semiconductor substrate 101 is exposed, whereby the side-wall spacers 113 are formed. The side-wall spacers 113 are formed also on the side walls of the gate electrodes of the MISFETs constituting the peripheral circuits. The surfaces of the semiconductor substrate 101 and control gate electrodes 108 exposed by the above etching are oxidized again, thereby to form a silicon oxide film 109. Subsequently, using the floating gate electrodes 106, control gate electrodes 108 and side-wall spacers 113 as a mask, an n-type impurity, for example, arsenic (As) is introduced at a dose of approximately $1 \times 10^{16}$ atoms/cm² by ion implantation, whereby an $n^+$-type semiconductor region 111 is formed. The high impurity concentration layers of the source and drain regions of the N-channel MISFETs constituting the peripheral circuits are simultaneously formed by this step of ion implantation. By the way, regions where the P-channel MISFETs of the peripheral circuits are to be constructed are covered with a mask made of resist films beforehand lest the aforementioned n-type impurity should be introduced thereinto. This mask made of the resist films are removed after the ion implantation. After the formation of the N-channel MISFETs, the N-channel regions of the peripheral circuits and the memory cell region are covered with a mask made of resist films though the mask is not shown here. Thereafter, a P-type impurity, for example, boron (B) is selectively introduced into the P-channel MISFET regions of the peripheral circuits by ion implantation, thereby to form the source and drain regions of the P-channel MISFETs. The mask made of the resist films as has covered the N-channel MISFETs and the memory cell region is removed after the ion implantation.

Subsequently, as illustrated in Fig. 30, an insulator film 114 made of a PSG film is formed on the whole surface of the resultant semiconductor substrate 101 by, for example, CVD. Thereafter, the contact holes 115 and the data lines DL made of aluminum films as shown in Figs. 20 and 21 and a final passivation film not shown are formed.

As thus far described, according to the manufacturing method of this embodiment, the memory cells can be formed by nearly the same steps as those of the N-channel MISFETs which constitute the peripheral circuits such as address buffer circuits, decoder circuits and sense amplifier circuits.

According to the present invention, a gate insulator film is locally thickened at the edge part of a drain region lying in contact with a channel region, whereby (1) electric fields which appear at the edge parts of the drain regions within a semiconductor are moderated in a program mode in which a high write voltage is applied to only the drain regions in a channel cutoff state. Also, an electric field which is applied to the part of the gate insulator film between a floating gate electrode 106 and the edge part of the drain region is weakened. Thus, the immunity against the drain disturb phenomenon is enhanced. (2) In a write mode which is based on the injection of channel hot electrons, an electric field which appears at the edge part of the drain region within the semiconductor is intensified contrariwise to the case of the program mode. Thus, enhancement in the writing speed or reduction in the write voltage is realized. (3) Conjointly with the fact that the extension of the drain region underneath the floating gate electrode 106 is short, the capacitance between the drain region and the floating gate electrode 106 is lowered. Meanwhile, a drain current in a read mode hardly changes. This results in the effect that reading information at high speed becomes possible.

It is accordingly possible to realize without spoiling the erasing characteristics the conditions that the generation efficiency of hot carriers is high when the high write voltage is applied to both the drain region and a control gate electrode, and that the generation efficiency of hot carriers is low when the high voltage is applied to only the drain region. Therefore, the characteristics of writing, erasing and holding information can be totally enhanced. Moreover, in the read mode, the capacitance between the floating gate electrode and the drain region can be lowered without lessening a channel current, so that the information reading speed can be raised.

(Embodiment 3)

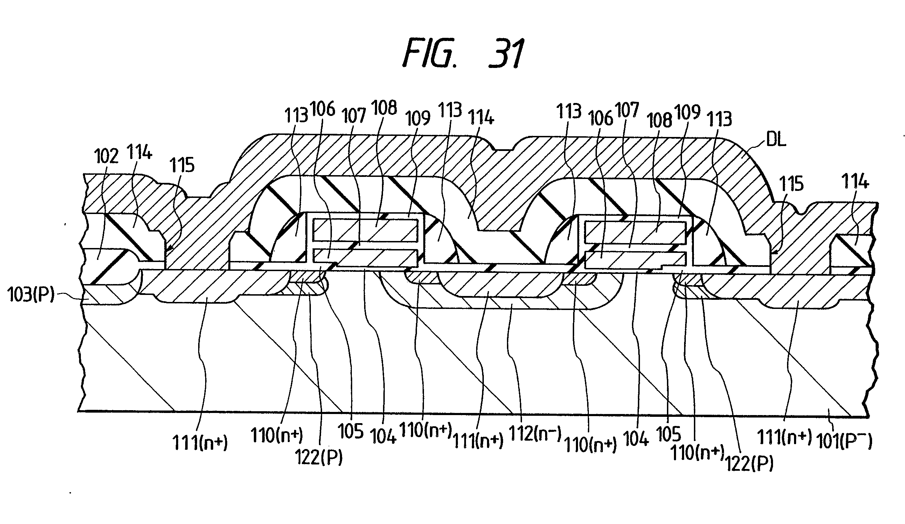

Next, the third embodiment of the present invention will be described with reference to Fig. 31. Likewise to the second embodiment, this embodiment corresponds to the case(III) of the expedient for solving the problems.

Fig. 31 is a sectional view of 2 bits of memory cells in this embodiment.

This embodiment is such that, in addition to the structure of Embodiment 2, a p-type semiconductor region 122 is provided under the $n^+$-type semiconductor region 110 which constitutes the edge part of the drain region. The p-type semiconductor region 122 has its end part nearer to the channel region defined by the floating gate electrode 106 and the control gate electrode 108, and has its length in the gate width direction defined by the field insulator film 102.

The feature of this embodiment consists in that the p-type semiconductor region 122 is provided only under the $n^+$-type semiconductor region 110, not existing at the bottom of the $n^+$-type semiconductor region 111. As a result, the generation efficiency of hot carriers at the edge part of the drain region as required for enhancing the writing characteristics can be effectively heightened while increase in the junction capacitance between the drain region and the semiconductor substrate 101 is suppressed to the required minimum. Moreover, since the spread of the drain depletion layer into the channel region can be suppressed, shortening the channel can be carried forward without incurring the undesirable punch-through phenomenon.

(Embodiment 4)

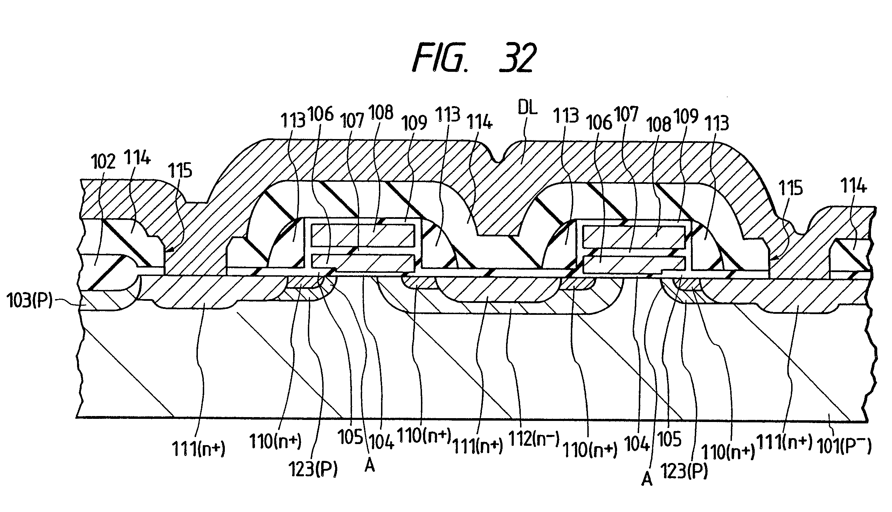

Next, the fourth embodiment of the present invention will be described with reference to Fig. 32. Likewise to the second and third embodiments, this embodiment corresponds to the case(III) of the expedient for solving the problems.

Fig. 32 is a sectional view of 2 bits of memory cells in this embodiment.

This embodiment is such that a p-type semiconductor region 123 corresponding to the p-type semiconductor region 122 in Embodiment 3 is provided, not only at the bottom part of the $n^+$-type semiconductor region 110 of the drain region, but also on the side surface A thereof nearer to the channel. As in the case of Embodiment 3, the p-type semiconductor region 123 has its end part nearer to the channel region defined by the floating gate electrode 106 and the control gate electrode 108 and has its length in the gate width direction defined by the field insulator film 102.

In this embodiment, the p-type semiconductor region 123 lying in contact with the $n^+$-type semiconductor region 110 of the drain extends up to the surface of the semiconductor substrate 101. Therefore, enhancements in the writing efficiency and the punch-through immunity can be realized, and it is also permitted to control the threshold voltage by the impurity concentration of this region 123. On this occasion, the $n^+$-type semiconductor region 110 and $n^-$-type semiconductor region 112 which constitute the source region are spaced from the p-type semiconductor region 123 with the $p^-$-type channel region intervening therebetween, so that the threshold voltage can be set without adversely affecting the source junction breakdown voltage.

(Embodiment 5)

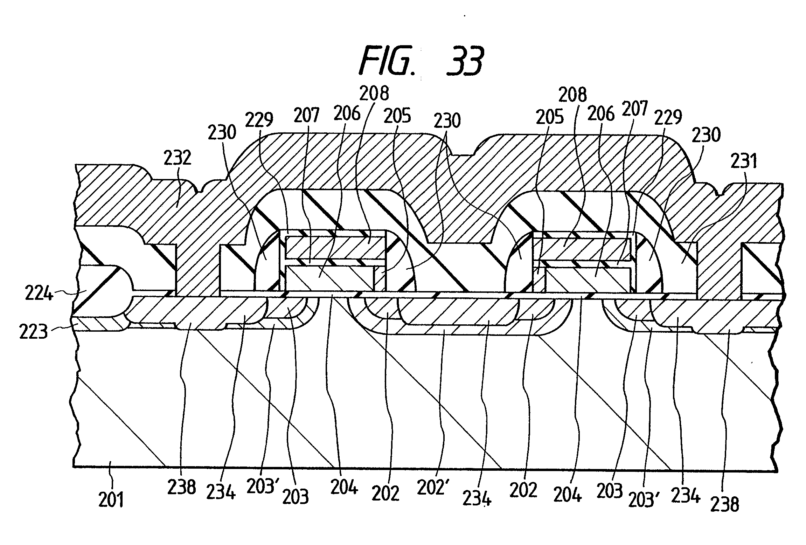

Next, the fifth embodiment of the present invention will be described with reference to Fig 33. This embodiment corresponds to the cases (II) and (IV) of the expedients for solving the problems.

Fig. 33 is a sectional view of 2 bits of memory cells in this embodiment. Now, the manufacturing steps of the memory cell will be described, and the features thereof will be clarified.

First, a P-type silicon substrate 201 is formed with an oxide film 224 for device isolation and a boron channel stop layer 223 by LOCOS.

Subsequently, a gate insulator film 204 having a thickness of about 10 nm is formed by an ordinary process for forming a gate insulator film.

In order to form the floating gate (at numerals 205 and 206) of each memory cell, the first polycrystalline silicon film (about 100 - 200 nm thick) is formed on the resultant substrate, and it is doped with boron at a concentration of $10^{18}$ - $10^{19}$ $cm^{-3}$. The polycrystalline silicon film is vertically worked by a photoetching process and an anisotropic dry etching process which employs a gas mainly consisting of $CCl_4$, and it is left behind in the shape of a belt extending in the W direction of the memory cell (perpendicular to the sheet of Fig. 33), at only its part which forms the floating gate (205 and 206). Thereafter, the surface of the resultant polycrystalline silicon film is thermally oxidized, whereby the inter-layer insulator film 207 (about 20 nm thick) of each memory cell is formed.

Subsequently, a tungsten poly-cide (polycrystalline silicon/$WSi_2$) film (about 250 - 500 nm thick) is formed on the whole surface. At the next step, the tungsten poly-cide film of the memory cell is vertically worked by a photoetching process and an anisotropic etching process which employs a gas mainly consisting of $CCl_4$ and $SF_6$. At this time, the section of the memory cell taken in the direction of a channel becomes as shown in Fig. 33.

Subsequently, the gates are covered with an oxide film 229 by performing light oxidation. Thereafter, phophorus at a dose of approximately $10^{14}$ $cm^{-2}$ is introduced into the source side of the memory cell by ion implantation by utilizing a photoetching process, and the phosphorus is diffused by annealing at about 900 - 1000 °C, whereby the low-concentration source diffusion layer $202'$ of the memory cell is formed. Likewise, boron at a dose of approximately $10^{14}$ $cm^{-2}$ is introduced into the drain side of the memory cell by ion implantation, whereby the low-concentration drain diffusion layer $203'$ of the memory cell is formed.

Next, arsenic at a dose of at least $10^{15}$ $cm^{-2}$ is introduced by ion implantation, thereby to form the high-concentration source diffusion layer 202 and high-concentration drain diffusion layer 203 of the memory cell. Thereafter, the oxide film formed on the surfaces of the gate electrodes of each memory cell by the foregoing light oxidation is removed at only the side surfaces of the gate electrodes nearer to the source region by a photoetching process. Thereafter, the resultant structure is heat-treated in an atmosphere containing phosphorus, whereby the phosphorus is diffused into the polycrystalline silicon film of the region 205 located at the end face part of the floating gate electrode nearer to the source region, and the region 205 comes to have a high impurity concentration of at least $10^{20}$ $cm^{-3}$. The width of the high concentration region 205 is about 0.1 - 0.2 $\mu$m from the end face of the floating gate (the lateral junction depth of each of the diffused layers 202 and 203 of the memory cell is at least 0.3 $\mu$m). Although, in this embodiment, the atmosphere containing phosphorus is employed, it is a matter of course that a high concentration region 205 of boron can be quite similarly formed by employing a boron atmosphere.

Next, side walls 230 made of $SiO_2$ are formed. Further, high-concentration N-type diffusion layers 234 are formed by the ion implantation of arsenic. Subsequently, a PSG or BPSG film 231 is formed on the whole surface and is provided with a hole, through which a phosphorus ion implantation portion 238 for lowering the contact resistance of the drain region with Al wiring to be formed next is formed, followed by the formation of the Al wiring 232. Lastly, an $SiO_2$ film as a passivation film is formed. Then, the memory cell according to this embodiment is finished up.

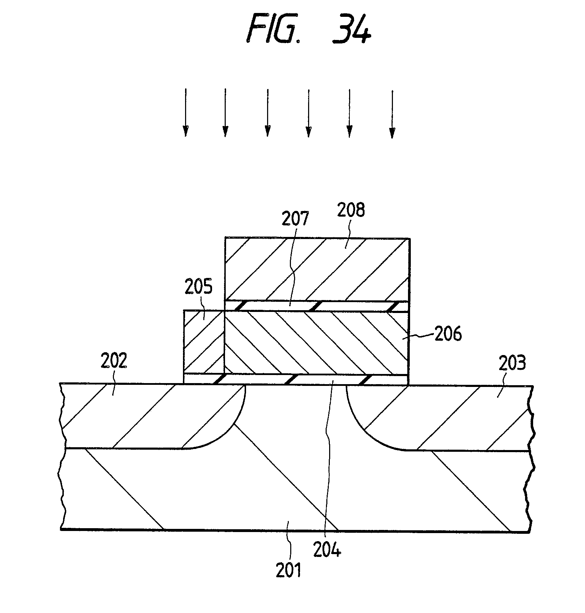

Although, in the embodiment, the high concentration region 205 of the floating gate has been formed by the heat treatment in the atmosphere containing the impurity, it can alternatively be formed in such a way that, as illustrated in Fig. 34, a control gate 208 is worked to be shorter than the floating gate electrode, whereupon the ions of phosphorus or boron are implanted using the control gate 208 as a mask.

Although, in the above, the case of the N-channel memory cells employing the P-type semiconductor substrate has been described, it is a matter of course that the opposite conductivity types may well be adopted. Besides, the present invention is not restricted to the foregoing embodiment, but it can of course be variously modified within the scope not departing from the purport thereof.

In this embodiment, in performing an erase operation, namely, the operation of applying a voltage to a source electrode and drawing out electrons within a floating gate into a source region on the basis of the FN tunneling, only a portion sandwiched between the high concentration region of the floating gate and the source region is subjected to an intense electric field and is operated as a tunenling region. In contrast, a region sandwiched between the low concentration region (opposite in the conductivity type to the source region) of the floating gate and the source region layer becomes equivalent to a thickened gate insulator film because a depletion layer spreads inside the floating gate, and an electric field is relieved in this region. In consequence, a depleted region to appear in the erase mode can be made smaller, and a source-susbstrate leakage current having hitherto flowed to a substrate can be eliminated. Since the FN tunneling current can be enlarged owing to the improvements, the erasing speed can be raised, and the source voltage may be low. Further, the quality of the gate insulator film can be suppressed from being degraded by hot holes generated in the depleted region. As a result, it is possible to provide a nonvolatile memory which is of low power consumption and high reliability and which is electrically erasable and easy of use.

Meanwhile, the edge part of the floating gate electrode nearer to a drain region has an impurity profile in which the conductivity type is opposite to that of the drain region and in which the impurity concentration is low. Therefore, when a high write voltage is applied to only the drain region in a channel cutoff state, a depletion layer spreads inside the low concentration part of the floating gate electrode. Thus, the low concentration part becomes equivalent to a thickened gate insulator film, and an electric field to appear at the edge part of the drain region within the semiconductor substrate is relieved. Also an electric field to be applied to the part of the gate oxide film between the floating gate electrode and the edge part of the drain region is weakened. In this way, it is possible to provide a nonvolatile memory which has an excellent immunity against the drain disturb phenomenon and a high reliability.

## Claims

1. An insulated-gate field effect transistor having a floating gate electrode (16) provided on a gate insulator film (14) and a control gate electrode (18) provided above the floating gate electrode (16) through an inter-layer insulator film (17) in an at least partly stacked manner, characterized by means (20) for locally modulating an electric field to be applied to said gate insulator film (14) at a part at which said floating gate electrode (16) overlaps at least one of the drain and source regions (21) of said transistor.

2. An insulated-gate field effect transistor having a floating gate electrode (106) provided on a gate insulator film (104, 105), and a control gate electrode (108) provided above the floating gate electrode (106) through an inter-layer insulator film (107) in an at least partly stacked manner, characterized in that said gate insulator film (104, 105) is locally thinned in a region (104) in which said floating gate electrode (106) overlaps at least one of the drain and source regions (110, 111) of said transistor, and that the thinned region is limited onto a high impurity concentration region (110) which constitutes said drain or source region.

3. The semiconductor device of claim 2, wherein the junction breakdown voltages of said drain and source regions (110, 111) differ from each other, and said gate insulator film (104, 105) is locally thinned at an edge part of said floating gate electrode (106) lying in contact with the region of higher breakdown voltage.

4. An insulated-gate field effect transistor having a floating gate electrode (106) provided on a gate insulator film (104, 105) and a control gate electrode (108) provided above the floating gate electrode (106) through an inter-layer insulator film (107) in an at least partly stacked manner, characterized in that said gate insulator film (104, 105) is locally thickened in a region (105) in which said floating gate electrode (106) overlaps at least one of the drain and source regions (110, 111) of said transistor, and that the thickened region (105) extends onto a channel region of said transistor.

5. The semiconductor device of claim 4, wherein the locally-thickened region (105) of said gate insulator film (104, 105) covers a depletion region which spreads from a junction of said source or said drain region (110, 111) into said channel region.

6. The semiconductor device of claim 4 or 5, wherein the junction breakdown voltages of said drain and source regions (110, 111) differ from each other, and said gate insulator film (104, 105) is locally thickened at an edge part of said floating gate electrode (106) lying in contact with the region of higher breakdown voltage.

7. An insulated-gate field effect transistor having a floating gate electrode (205, 206) provided on a gate insulator film (204) and a control gate electrode (208) provided above the floating gate electrode (205, 206) through an inter-layer insulator film (207) in an at least partly stacked manner, characterized in that a region (205) of said floating gate electrode (205, 206) which overlaps at least one of the source and drain regions (202, 203, 234) of said transistor has a high impurity concentration, while the remaining region (206) of said floating gate electrode (205, 206) is doped with an impurity having a conductivity type opposite to that of said drain and source regions (202, 203, 234) at a low impurity concentration.

8. The semiconductor device of claim 7, wherein the high impurity concentration region (205) of said floating gate electrode (205, 206) is limited over a high impurity concentration region (202) which constitutes said drain or source region.

9. The semiconductor device of claim 7 or 8, wherein the high impurity concentration region (205) has an impurity concentration of at least $10^{20}$ cm$^{-3}$, while said remaining region (206) has an impurity concentration of at most $10^{19}$ cm$^{-3}$.

10. The semiconductor device of any one of claims 7 to 9, wherein the width of said floating gate electrode (205, 206) in a direction of the channel region of said transistor is greater than that of said control gate electrode (208).

11. The semiconductor device of any one of claims 7 to 10, wherein the junction breakdown voltages of said drain and source regions (202, 203, 234) differ from each other, and an edge part of said floating gate electrode (205, 206) lying in contact with the region (202) of higher breakdown voltage has the high impurity concentration.

12. The semiconductor device of claim 11, wherein said region of higher junction breakdown voltage between said drain and source regions (202, 203, 234) has at least its edge part, which is nearer to the channel region of said transistor, made of a layer which has a lower impurity concentration lower than the region of lower junction breakdown voltage.

13. The semiconductor device of claim 11 or 12, wherein the region of lower junction breakdown voltage between said drain and source regions (202, 203, 234) is formed of a high impurity concentration layer, and a semiconductor region which has a conductivity type identical to that of a semiconductor substrate (201) of said transistor and an impurity concentration higher than that of said substrate is provided in contact with said high impurity concentration layer.

14. The semiconductor device of any one of claims 11 to 13, wherein hot carriers generated in the region of lower junction breakdown voltage between said drain and source regions (202, 203, 234) are injected into said floating gate electrode (205, 206) and held therein, thereby to electrically write and store information.

15. The semiconductor device of any one of claims 11 to 14, wherein charges stored in said floating gate electrode (205, 206) are drawn out into the region of higher junction breakdown voltage between said drain and source regions (202, 203, 234) by tunnel transition, thereby electrically to erase stored information.

# FIG. 1

# FIG. 2

| MEANS FOR MODULATION OF ELECTRIC FIELD / REGION | THICKNESS CONTROL OF GATE OXIDE FILM UNDER FLOATING GATE | POLARITY OR CONCENTRATION CONTROL OF IMPURITY IN FLOATING GATE |
|---|---|---|
| SOURCE | (I) | (II) |
| DRAIN | (III) | (IV) |

FIG. 3

FIG. 4

FIG. 5

# FIG. 6

# FIG. 7

## FIG. 8

12      32    31

13(P⁺)

11(P)

## FIG. 9

12      16'    14

13(P⁺)

11(P)

EP 0 298 430 A2

FIG. 10

## FIG. 11

12

33 18' 17 16' 14

13(P⁺)

11(P)

## FIG. 12

17 18 19     17 18 19

12     16'

13(P⁺)

14     11(P)     14

EP 0 298 430 A2

FIG. 13

FIG. 14

EP 0 298 430 A2

FIG. 15

FIG. 16

EP 0 298 430 A2

## FIG. 17

18  19  20  36  20  19  18

16 17                    17 16

12

13(P⁺)

22(P⁺)  14  15  23(n⁻)  11(P)  15  14  22(P⁺)

## FIG. 18

16  17  18          18  17  16

                19          19
12                   20    20

13(P⁺)

21(n⁺)  22(P⁺)  14  15  21(n⁺)  23(n⁻)  11(P)  15  14  21(n⁺)  22(P⁺)

FIG. 19

EP 0 298 430 A2

FIG. 20

EP 0 298 430 A2

# FIG. 21

## FIG. 22

102
104 106 107 108

103(P)

101(P⁻)

## FIG. 23

106 107 108          106 107 108

102

104

103(P)

101(P⁻)

EP 0 298 430 A2

## FIG. 24

106 107 108 109
106 107 108 109

102

103(P)

104
104
101(P⁻)

## FIG. 25

109 108 107 106
106 107 108 109

102
120

103(P)

105 104
104 105
101(P⁻)

FIG. 26

FIG. 27

FIG. 28

FIG. 29

FIG. 30

FIG. 31

# FIG. 32

EP 0 298 430 A2

FIG. 33

FIG. 34